# EUROPÄISCHE PATENTANMELDUNG

(11) **EP 4 040 509 A1**
(43) Veröffentlichungstag der Anmeldung: **10.08.2022**
(21) Anmeldenummer: 21155266.6
(22) Anmeldetag: 04.02.2021
(51) Int. Cl.: H01L 31/18, H01L 31/049, B32B 37/00, B32B 38/18, H01L 21/67

(54) **VORRICHTUNG UND VERFAHREN ZUM REPARIEREN EINES SOLARMODULS**

(71) Anmelder: SC-Refit GmbH, 22085 Hamburg (DE)
(72) Erfinder: STRAUB, Christian Frido Otto Emil, 22337 Hamburg (DE); JAKOBI, Kai-Marten, 20251 Hamburg (DE); GACITUA ANABALON, Roberto Luis, 21255 Tostedt (DE)
(74) Vertreter: Seemann & Partner Patentanwälte mbB

(57) **Zusammenfassung**

Die Erfindung betrifft u.a. eine Vorrichtung (10) zum Reparieren eines Solarmoduls (100) mit einem längserstreckten Auflagentisch (12) für ein Solarmodul (100), wobei der Auflagentisch (12) für ein Solarmodul (100) eine Auflagenfläche (14) aufweist, und mit einer rotierbaren Aufnahmerolle (30) zum Aufnehmen eines Klebefolienabschnitts endlicher Länge für die Rückseite des zu reparierenden Solarmoduls (100), wobei eine Halterung (20) für die Aufnahmerolle (30) vorgesehen ist, wobei die Aufnahmerolle (30) für den Klebefolienabschnitt mittels der Halterung (20) am und/oder über dem Auflagentisch (12) gehaltert angeordnet ist, wobei die Halterung (20) für die rotierbare Aufnahmerolle (30) in Bezug auf den Auflagentisch (12) entlang der Längserstreckung des Auflagentisches (12) bewegbar ist oder bewegt wird und die Halterung (20) für die rotierbare Aufnahmerolle (30) in Bezug auf den Auflagentisch (12) entlang der Längserstreckung des Auflagentisches (12) quer zur Längserstreckung des Auflagentisches (12) relativ bewegbar ist, so dass der Abstand zwischen dem Auflagentisch (12) und der Aufnahmerolle (30) variabel einstellbar ist.

## Beschreibung

Die Erfindung betrifft eine Vorrichtung zum Reparieren eines, insbesondere fertig hergestellten, Solarmoduls sowie ein Verfahren zum Reparieren eines, insbesondere fertig hergestellten Solarmoduls.

Außerdem betrifft die Erfindung eine Verwendung einer Vorrichtung zum Reparieren eines insbesondere fertig hergestellten Solarmoduls.

Es ist bekannt, dass bei Photovoltaikmodulen, die auch als Solarmodule bezeichnet sind, auf der Rückseite zum Schutz der Module eine Verbundfolie oder dergleichen als Backsheet vorgesehen ist. Die Verbundfolien verfügen üblicherweise hierbei über mehrere Schichten bzw. Lagen. Typischerweise sind die Schichten z.B. in der Reihenfolge Polyvinylfluoridschicht / Kleber / Polyesterschicht (z.B. Polyethylenterephthalat, PET), Kleber / Polymerschicht oder Polyvinylfluoridschicht angeordnet. Die Verbundfolien sind hierbei auf der Rückseite der Solarmodule angebracht und schützen die Module vor Witterungseinflüssen oder anderen äußeren Einflüssen.

Ferner ist aus WO 2019/068929 A1 ein Verfahren zum rückseitigen Abdecken von Photovoltaikmodulen bekannt.

Eine Aufgabe der Erfindung besteht darin, die Reparatur von, vorzugsweise bereits fertig hergestellten, Solarmodulen zu vereinfachen bzw. zu verbessern, wobei eine hohe Prozesssicherheit gewährleistet werden soll.

Die Aufgabe wird gelöst durch eine Vorrichtung zum Reparieren eines, insbesondere fertig hergestellten, Solarmoduls, insbesondere zum Aufbringen einer Klebefolie auf die Rückseite eines, vorzugsweise auf der Rückseite defekten, Solarmoduls, mit einem längserstreckten, insbesondere horizontal ausgerichteten und/oder ortsfesten, Auflagentisch für ein Solarmodul, wobei der Auflagentisch für ein Solarmodul eine Auflagenfläche aufweist, und mit einer, vorzugsweise um eine horizontal ausgerichtete Rotationsachse, rotierbaren Aufnahmerolle zum Aufnehmen eines Klebefolienabschnitts endlicher Länge für die Rückseite des zu reparierenden Solarmoduls, wobei eine Halterung für die Aufnahmerolle vorgesehen ist, wobei die Aufnahmerolle für den Klebefolienabschnitt mittels der Halterung am und/oder über dem Auflagentisch, insbesondere oberhalb des Auflagentisches, gehaltert angeordnet ist, wobei die Halterung für die rotierbare Aufnahmerolle in Bezug auf den Auflagentisch entlang der Längserstreckung des Auflagentisches bewegbar ist oder bewegt wird und die Halterung für die rotierbare Aufnahmerolle in Bezug auf den Auflagentisch entlang der Längserstreckung des Auflagentisches quer, insbesondere senkrecht, zur Längserstreckung des Auflagentisches relativ bewegbar ist, so dass der, insbesondere vertikale, Abstand zwischen dem Auflagentisch und der Aufnahmerolle variabel einstellbar ist.

Der Gedanke der Erfindung besteht darin, dass bei bestehenden Solarmodulen bzw. Photovoltaikmodulen das Aufbringen eines selbstklebenden Klebefolienabschnitts endlicher Länge als Reparaturfolie auf eine defekte Rückseitenfolie (z.B. eine poröse Verbundfolie) eines Solarmoduls mittels der erfindungsgemäßen Vorrichtung vereinfacht wird und außerdem mittels der Vorrichtung eine Reparatur von Solarmodulen mit einer hohen Wiederholbarkeit und einer hohen Prozesssicherheit ermöglicht wird, so dass innerhalb einer vorbestimmten Zeit eine größere Anzahl von Solarmodulen schnell repariert werden kann. Hierzu wird beispielsweise die Vorrichtung an einem Feld mit Solarmodulen aufgebaut, so dass einzelne defekte Solarmodule unter Verwendung der Vorrichtung vor Ort schnell durch Aufbringen des Klebefolienabschnitts auf den beschädigten Rückseiten der zu reparierenden Solarmodule instandgesetzt werden und zur weiteren Stromerzeugung wiederverwendet werden.

Darüber hinaus wird sichergestellt, dass der auf der Rückseite, insbesondere vollflächig, aufgebrachte Klebefolienabschnitt passgenau und fehlerfrei sowie vollständig auf die defekte Rückseitenfolie der Solarmodule aufgebracht wird, wodurch die elektrische Integrität der Solarmodule gewährleistet bzw. wiederhergestellt wird. Die Reparatur der bestehenden Solarmodule erfolgt hierbei vor Ort an einem Feld mit mehreren Solarmodulen. Als Klebefolienabschnitt wird hierbei eine Folie bzw. eine Verbundfolie, wie z.B. Verbundfolie aus Polyvinylfluorid, eingesetzt.

Zum Aufbringen des, vorzugsweise vollflächigen, Klebefolienabschnitts auf die Rückseite des Solarmoduls ist eine Aufnahmerolle oberhalb des Auflagentisches bzw. Auflagenfläche vorgesehen, wobei die Aufnahmerolle mittels einer am Auflagentisch angeordneten Halterung beweglich gehaltert ist. Nach der Anordnung des Klebefolienabschnitts auf der Außenseite bzw. der Umfangsfläche der Aufnahmerolle wird die Aufnahmerolle mittels der am Auflagentisch bewegbar angeordneten Halterung in Richtung des auf dem, vorzugsweise horizontal ausgerichteten, Auflagentisch angeordneten Solarmoduls bewegt, wobei hierbei der Klebefolienabschnitt durch Annäherung der Aufnahmerolle in Richtung des Solarmoduls in Kontakt mit der Rückseite des Solarmoduls gebracht wird und durch eine anschließende Abrollbewegung der Aufnahmerolle entlang des Auflagentisches bzw. des Solarmoduls der Klebefolienabschnitt auf die Rückseite des Solarmoduls, insbesondere durch das Eigengewicht der Aufnahmerolle, gepresst wird. Hierdurch wird die dem Solarmodul zugewandte Klebeseite des selbstklebenden Klebefolienabschnitts in Kontakt mit der vorhandenen rückseitigen Verbundfolie des Solarmoduls gebracht.

Insbesondere ist die Vorrichtung mit dem ortsfesten Auflagentisch ausgebildet, so dass die Aufnahmerolle in Bezug auf den ortsfesten Auflagentisch in vertikaler Richtung und in horizontaler Richtung bewegt wird. Der Auflagentisch weist vorzugsweise mehrere Standfüße auf, die an der Auflagenfläche des Auflagentisches angeordnet sind. Hierbei weist der Auflagentisch auch entsprechende Ausrichtmittel, z.B. an den Füßen auf, um den Auflagentisch bzw. die Auflagenfläche für das Solarmodul horizontal vor Ort, z.B. an einem Feld mit Solarmodulen, aufzustellen bzw. auszurichten.

Gemäß einer Weiterbildung ist bei der Vorrichtung vorgesehen, dass die Halterung für die Aufnahmerolle relativ zum, vorzugsweise ortsfesten, Auflagentisch in horizontaler Richtung und in vertikaler Richtung bewegbar ist, wobei insbesondere die Aufnahmerolle von einer Ruheposition in eine Arbeitsposition bringbar ist und/oder wobei insbesondere die Aufnahmerolle in einer Arbeitsposition mittels einer Verriegelungsvorrichtung in der vertikalen Position verriegelbar oder verriegelt ist. In der Ruheposition der Aufnahmerolle wird der Klebefolienabschnitt auf der Außenseite der einen Trommelkörper aufweisenden Aufnahmerolle angeordnet. In der Arbeitsposition wird der Klebefolienabschnitt von der Aufnahmerolle auf die Rückseite des Solarmoduls während einer Abrollbewegung der Aufnahmerolle aufgeklebt.

Um die Aufnahmerolle in vertikaler Richtung und in horizontaler Richtung zu bewegen, wird entsprechend die Halterung, an der die rotierbare Aufnahmerolle angeordnet ist, in ihrer Position in Bezug auf den Auflagentisch bzw. auf das fixierte Solarmodul auf der Auflagenfläche des Auflagentisches bewegt. In der Ruheposition der Aufnahmerolle, die vorzugsweise oberhalb in einem vorbestimmten Abstand zum Auflagentisch ist, wird der Klebefolienabschnitt auf die Umfangsfläche der Aufnahmerolle angeordnet, wobei anschließend die Aufnahmerolle in eine Arbeitsposition gebracht wird, so dass der auf die Aufnahmerolle angeordnete Klebefolienabschnitt in Richtung des zu reparierenden Solarmoduls mittels der Halterung bewegt wird und die außenseitige Klebeschicht des Klebefolienabschnitts in Kontakt mit der Rückseite des Solarmoduls gebracht wird.

Um die Aufnahmerolle während der (Abroll-)Bewegung der Aufnahmerolle längs des Auflagentisches und bei Andrucks des Klebefolienabschnitts auf die Rückseite des Solarmoduls in der vertikalen Position zu fixieren, wird die Bewegung der Aufnahmerolle in vertikaler Richtung mittels der Verriegelungseinrichtung verhindert, so dass während des Aufbringvorgangs des Klebefolienabschnitts auf die Rückseite des Solarmoduls die Aufnahmerolle ausschließlich durch einen Abrollvorgang auf dem Solarmodul entlang des Auflagentisches bewegt wird.

In einer Weiterbildung der Vorrichtung ist außerdem vorgesehen, dass für die Bewegung der Halterung wenigstens ein Halterungsantrieb, insbesondere ein Motor oder ein manueller Antrieb, vorgesehen ist. Hierdurch ist es möglich, die Aufnahmerolle beispielsweise von einer Ruheposition in eine Arbeitsposition zu bewegen. Dabei kann vorgesehen sein, dass der Halterungsantrieb als elektrischer Motor oder als manuell betätigbarer Kurbelantrieb oder dergleichen ausgebildet ist. Ferner ist es im Rahmen der Erfindung vorgesehen, dass beispielsweise ein Antrieb, z.B. ein Kurbelantrieb, für die Bewegung der Aufnahmerolle mittels der Halterungsanordnung in vertikaler Richtung und ein Antrieb, z.B. ein Kurbelantrieb, für die Bewegung der Aufnahmerolle mittels der Halterungsanordnung in horizontaler Richtung vorgesehen sind.

Insbesondere weist die Aufnahmerolle eine oder mehrere, insbesondere zylinderförmige oder teilzylinderförmige, Rollensegmente auf. Bei der Ausbildung der Aufnahmerolle mit mehreren Rollensegmenten ist hierbei die Aufnahmerolle modular durch die Rollensegmente aufgebaut, so dass beispielsweise durch die Anpassung von unterschiedlich breiten Rollensegmenten entsprechend der Breite der zu reparierenden Solarmodule eine Aufnahmerolle mit einer passenden Gesamtbreite für die zu reparierenden Solarmodule bereitgestellt wird. Hierbei können die Rollensegmente miteinander entsprechend kombiniert werden. Dazu sind in einer Ausgestaltung die Rollensegmente mit der gleichen Breite ausgebildet. In einer weiteren Ausgestaltung ist es vorgesehen, dass die Rollensegmente unterschiedliche Breiten aufweisen.

Vorzugsweise sind die oder mehrere Rollensegmente miteinander koppelbar, so dass je nach Breite der zu reparierenden Solarmodule eine entsprechende Aufnahmerolle mit einer damit korrespondierenden Gesamtbreite bereitgestellt wird.

Des Weiteren zeichnet sich eine Ausgestaltung der Vorrichtung dadurch aus, dass die, insbesondere zylinderförmige oder teilzylinderförmige, Aufnahmerolle oder die Rollensegmente Befestigungsmittel, insbesondere Befestigungsklemmen oder mit Unterdruck beaufschlagbare Saugvorrichtungen, zum Befestigen des, vorzugsweise einzelnen, Klebefolienabschnitts endlicher Länge auf der Außenseite der Aufnahmerolle aufweisen. Dadurch wird gewährleistet, dass der aufzubringende Klebefolienabschnitt sicher auf der Aufnahmerolle angeordnet wird. Im Rahmen der Erfindung können hierbei auch mechanische Befestigungsmittel, wie z.B. Klemmen, vorgesehen sein.

Gemäß einer bevorzugten Ausgestaltung ist bei der Vorrichtung weiterhin vorgesehen, dass die Aufnahmerolle einen inneren Rahmen für die Rollensegmente aufweist, wobei die Rollensegmente auf oder an dem inneren Rahmen der Aufnahmerolle angeordnet oder anordbar sind. Hierbei ist beispielsweise der innere Rahmen als Gestell ausgebildet, an dem die Rollensegmente angeordnet werden oder sind. Durch den inneren Rahmen ist es möglich, schnell die Rollensegmente der Aufnahmerollen auszutauschen, wodurch es ermöglicht ist, für die Reparatur von Solarmodulen die bevorzugte Breite der Aufnahmerolle entsprechend schnell anzupassen.

Darüber hinaus ist gemäß einer Ausführungsform der Vorrichtung vorgesehen, dass die Aufnahmerolle und/oder die Rollensegmente in Umfangsrichtung eine Aussparung für einen Ausschnitt des Klebefolienabschnitts endlicher Länge aufweisen. Durch die Aussparung in der Aufnahmerolle wird ein Freiraum an der Aufnahmerolle bereitgestellt, wodurch beim Abrollvorgang die Aufnahmerolle nicht gegen eine elektrische Modulanschlussdose auf der Rückseite des Solarmoduls drückt. Dadurch wird verhindert, dass die elektrische, rückseitige Modulanschlussdose beim Reparaturvorgang durch Aufbringen des Klebefolienabschnitts auf der Rückseite des Solarmoduls beschädigt wird, da die Aussparung der Aufnahmerolle nicht gegen die Modulanschlussdose gedrückt wird. Entsprechend ist der aufzubringende Klebefolienabschnitt mit einer Aussparung im Ausschnitt für die Modulanschlussdose auf der Rückseite des Solarmoduls versehen.

Darüber hinaus ist es bei der Vorrichtung bevorzugt, dass der Auflagentisch eine Fixierungsvorrichtung für das, insbesondere zu reparierende, Solarmodul aufweist. Dadurch wird ermöglicht, dass das Solarmodul verrutschsicher auf der Auflagenfläche des Auflagentisches angeordnet ist, wodurch ein Verrutschen des Solarmoduls, insbesondere bei dem Reparaturvorgang durch Aufbringen des Klebefolienabschnitts, verhindert wird.

Weiterhin zeichnet sich eine Ausführungsform der Vorrichtung dadurch aus, dass die Vorrichtung eine Aufnahmeeinrichtung für einen Klebefolienvorrat, insbesondere eine Klebefolienrolle, aufweist, wobei insbesondere die Aufnahmeeinrichtung an einer Stirnseite und/oder unterhalb der Auflagenfläche des Auflagentisches angeordnet ist. Mittels der Aufnahmeeinrichtung wird oder ist z.B. eine Klebefolienrolle als Klebefolienvorrat drehbar gelagert, wobei von der drehbar gelagerten Klebefolienrolle die Klebefolie abgezogen wird. Die Aufnahmeeinrichtung weist in einer Ausgestaltung z.B. zwei parallel zu einander ausgerichtete und (mit-)rotierbare Walzen auf, auf denen die Klebefolienrolle aufliegt.

Vorzugsweise weist die Vorrichtung wenigstens eine Schneidvorrichtung zum Schneiden eines Klebefolienabschnitts von einem Klebefolienvorrat, insbesondere eine Klebefolienrolle, auf, wobei insbesondere die wenigstens eine Schneidvorrichtung an einer Stirnseite des Auflagentisches und/oder oberhalb der Aufnahmeeinrichtung für einen Klebefolienvorrat angeordnet ist und/oder wobei insbesondere eine Schneidvorrichtung als Längenschneidvorrichtung zum Schneiden der Länge des Klebefolienabschnitts und/oder eine Schneidvorrichtung als Breitenschneidvorrichtung zum Schneiden der Breite des Klebefolienabschnitts ausgebildet ist. Durch die Bereitstellung von wenigstens einer Schneidvorrichtung oder mehreren Schneidvorrichtungen ist es möglich, vor Ort einen passenden Klebefolienabschnitt von einem Klebefolienvorrat, insbesondere einer Klebefolienrolle, an der Vorrichtung abzuschneiden, wobei es bevorzugt ist, mittels einer Längenschneidvorrichtung einen Klebefolienabschnitt von dem Klebefolienvorrat, insbesondere Klebefolienrolle, mit einer vorbestimmten Länge abzuschneiden und mittels einer Breitenschneidvorrichtung den Klebefolienabschnitt mit einer bestimmten Breite zuzuschneiden.

Vorzugsweise sind die Längenschneidvorrichtung und die Breitenschneidvorrichtung an der Stirnseite des Auflagentisches, insbesondere oberhalb der Aufnahmeeinrichtung für den Klebefolienvorrat bzw. der Klebefolienrolle, angeordnet. Die Längenschneidvorrichtung und die Breitenschneidvorrichtung weisen insbesondere wenigstens ein Schneidmesser oder dergleichen auf.

Die Handhabung der Vorrichtung wird außerdem dadurch verbessert, dass die Vorrichtung eine Ausschnittsschneidvorrichtung zum Schneiden eines Ausschnitts, insbesondere eines Lochs, in dem Klebefolienabschnitt für ein zu reparierendes Solarmodul aufweist. Dadurch wird ein Ausschnitt für beispielsweise eine elektrische Modulanschlussdose auf der Rückseite des Solarmoduls in den Klebefolienabschnitt geschnitten.

Zudem wird die Aufgabe gelöst durch ein Verfahren zum Reparieren eines, insbesondere fertig hergestellten, Solarmoduls, insbesondere zum Aufbringen einer Klebefolie auf die Rückseite eines, vorzugsweise auf der Rückseite defekten, Solarmoduls, wobei auf die Rückseite ein, insbesondere ein aus Polyvinylfluorid (PVF) bestehender, Klebefolienabschnitt endlicher Länge unter Verwendung einer, voranstehend beschriebenen, Vorrichtung zum Reparieren eines Solarmoduls aufgebracht wird, wobei der auf der Außenseite der Aufnahmerolle angeordnete Klebefolienabschnitt endlicher Länge mittels der Aufnahmerolle an die Rückseite des Solarmoduls angedrückt wird und durch eine, vorzugsweise lineare, Bewegung der Aufnahmerolle entlang des Auflagentisches die Aufnahmerolle auf der Rückseite des Solarmoduls abrollt und während der Abrollbewegung der Aufnahmerolle der Klebefolienabschnitt endlicher Länge auf die Rückseite des Solarmoduls aufgebracht wird. Während der Abrollbewegung der Aufnahmerolle wird hierbei der, insbesondere vollflächige, Klebefolienabschnitt endlicher Länge auf die Rückseite des Solarmoduls angedrückt. Zur Vermeidung von Wiederholungen wird auf die obigen Ausführungen in Bezug auf die beschriebene Vorrichtung zum Reparieren eines Solarmoduls ausdrücklich verwiesen.

Außerdem wir die Aufgabe gelöst durch eine Verwendung einer, voranstehend beschriebenen, Vorrichtung zum Reparieren eines, insbesondere fertig hergestellten, Solarmoduls zum Aufbringen einer, insbesondere eine aus Polyvinylfluorid (PVF) bestehende, Klebefolie auf die Rückseite eines, vorzugsweise auf der Rückseite defekten, Solarmoduls. Ergänzend wird auf die voranstehenden Ausführungen zur Vorrichtung ausdrücklich verwiesen.

Mittels der erfindungsmäßen Vorrichtung ist es möglich, passgenau einen Klebefolienabschnitt endlicher Länge sowie die passenden Ausschnitte für die Modulanschlussdosen der Solarmodule (Photovoltaikmodule) in einem Vorbereitungsschritt zu schneiden. Darüber hinaus gewährleistet die Vorrichtung ein exaktes Ausrichten und einen sauber ausgerichteten und fehlerfreien Auftrag des Klebefolienabschnitts auf die defekte Rückseitenfolie des Solarmoduls. Das Aufbringen erfolgt insbesondere unter Vermeidung von Blasen- und Wellenbildung des Klebefolienanschnitts sowie unter der Einhaltung der vom Hersteller des Klebefolienabschnitts bzw. der als Reparaturfolie bereitgestellten Klebefolie Parameter für den Auftrag. Die Vorrichtung erlaubt einen definierten, kontrollierten, wiederholbaren, hochwertigen Auftrag des passgenau in der Breite und in der Länge zugeschnittenen Klebefolienabschnitts auf das zu reparierende Solarmodul.

Weitere Merkmale der Erfindung werden aus der Beschreibung erfindungsgemäßer Ausführungsformen zusammen mit den Ansprüchen und den beigefügten Zeichnungen ersichtlich. Erfindungsgemäße Ausführungsformen können einzelne Merkmale oder eine Kombination mehrerer Merkmale erfüllen.

Im Rahmen der Erfindung sind Merkmale, die mit "insbesondere" oder "vorzugsweise" gekennzeichnet sind, als fakultative Merkmale zu verstehen.

Die Erfindung wird nachstehend ohne Beschränkung des allgemeinen Erfindungsgedankens anhand von Ausführungsbeispielen unter Bezugnahme auf die Zeichnungen beschrieben, wobei bezüglich aller im Text nicht näher erläuterten erfindungsgemäßen Einzelheiten ausdrücklich auf die Zeichnungen verwiesen wird. Es zeigen:
- Fig. 1: schematisch eine Ansicht einer erfindungsgemäßen Vorrichtung zum Reparieren eines Solarmoduls in einer perspektivischen Rückansicht und
- Fig. 2: schematisch eine perspektivische Frontansicht der Vorrichtung aus Fig. 1.

In den Zeichnungen sind jeweils gleiche oder gleichartige Elemente und/oder Teile mit denselben Bezugsziffern versehen, so dass von einer erneuten Vorstellung jeweils abgesehen wird.

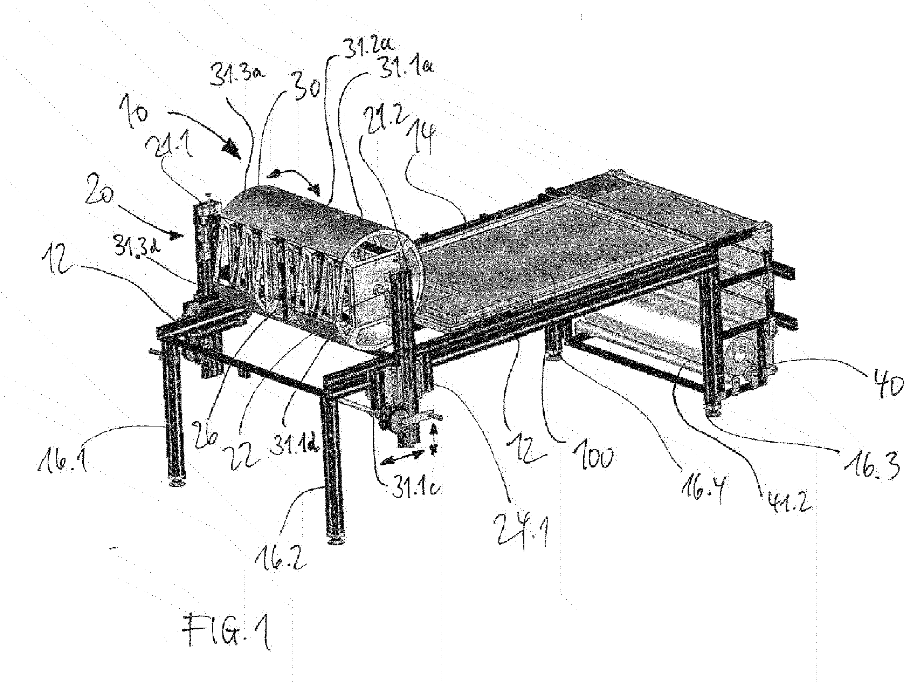

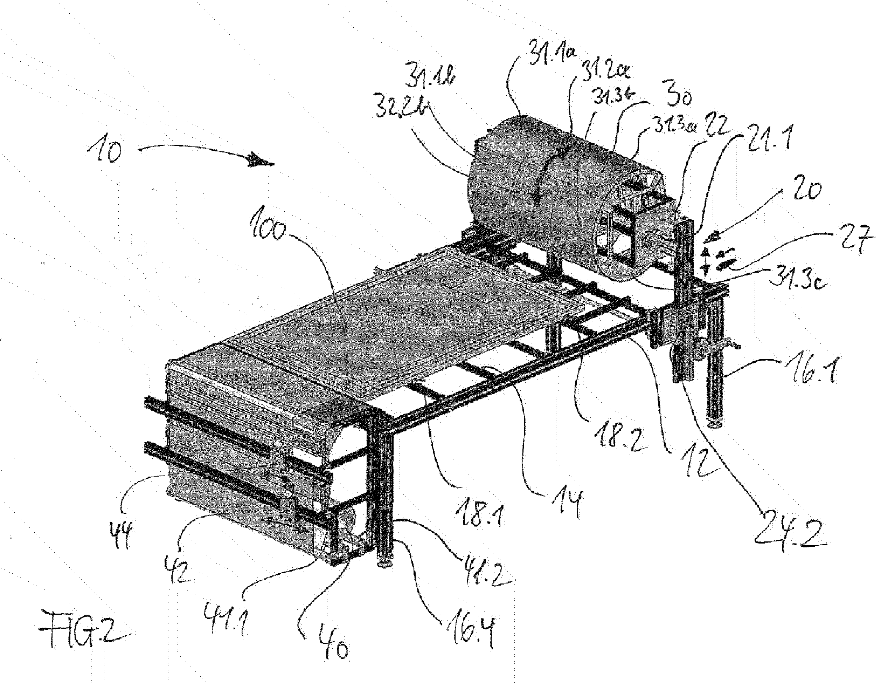

Fig. 1 und 2 zeigen jeweils perspektivische Ansichten einer erfindungsgemäßen Vorrichtung 10 zum Reparieren eines Solarmoduls 100.

Die Vorrichtung 10 weist einen Auflagentisch 12 auf, der eine rechteckförmige Auflagenfläche 14 umfasst. Der Auflagentisch 12 weist an den vier Ecken der rechteckförmigen Auflagenfläche 14 Standbeine 16.1, 16.2, 16.3, 16.4 auf. Die Standbeine 16.1, 16.2, 16.3, 16.4 verfügen an ihrer Unterseite, vorzugsweise in der Höhe einstellbare, Füße, so dass durch die Einstellung der Füße der Auflagentisch 12 bzw. die Auflagenfläche 14 horizontal an einem Aufstellungsort der Vorrichtung 10 ausgerichtet ist. Auf der Oberseite des Auflagentisches 12 liegt das Solarmodul 100 mit der Solarzellen aufweisenden Vorderseite auf der Auflagenfläche 14 auf, wobei die Rückseite des Solarmoduls 100 nach oben zeigt.

Auf der Oberseite des Auflagentisches 12 sind Schnellspanner 18.1, 18.2 angeordnet, die in ihrer Position auf der Auflagenfläche 14 verstellbar sind. Mittels der Schnellspanner 18.1, 18.2 wird das an einem Anschlag an der Längsseite des Auflagentisches 12 und an einem Anschlag an der Schmalseite des Auflagentisches 12 anliegende Solarmodul 100 positioniert und ausgerichtet und mittels der Schnellspanner 18.1, 18.2 auf der Auflagenfläche 14 fixiert.

An der Längsseite des Auflagentisches 12 ist eine Halterung 20 für eine Rolltrommel 30 angeordnet, die mittels der Halterung 20 mit dem Auflagentisch 12 verbunden ist. Die Halterung 20 weist auf beiden Längsseiten des Auflagentisches 12 jeweils eine Hubstange 21.1, 21.2 auf, die mittels einer Querstange bzw. Querverbindung 22 miteinander oberhalb der Auflagenfläche 14 verbunden sind. An der horizontalen Querverbindung 22 ist an einem Gestell die Rolltrommel 30 angeordnet.

Die Rolltrommel 30 weist auf der Außenseite mehrere modulartige Rollensegmente 31.1a, 31.1b, 31.1c, 31.1d, 31.2a, 31.2b, 31.2c, 31.2d, 31.3a, 31.3b, 31.3c, 31.3d auf, die an der Querverbindung 22 angeordnet sind. Die Rollensegmente 31.1a, ..., 31.3d sind an der Querverbindung 22 montierbar und demontierbar angebracht, so dass je nach Breite des Solarmoduls 100 die Rollensegmente 31.1a, ... , 31.3d derart an der Querverbindung 22 angeordnet werden, dass eine Rolltrommel 30 mit einer Gesamtreite bereitgestellt wird, die der Breite des entsprechenden zu reparierenden Solarmoduls 100 entspricht.

Wie aus Fig. 1 ersichtlich ist, ist die Rolltrommel 30 an der Rückseite offen, so dass die Rolltrommel 30 eine teilzylindermantelförmige Umfangsfläche aufweist, auf der ein Klebefolienabschnitt für das Solarmodul 100 mittels von (hier nicht dargestellten) Befestigungsmitteln, z.B. Klemmen oder dergleichen, angeordnet wird. Beispielsweise weist die Rolltrommel 30 hierfür mechanische Schnellspannmittel oder dergleichen auf. In einer anderen Ausgestaltung (hier nicht dargestellt) ist vorgesehen, dass die Rolltrommel 30 mit Unterdruck beaufschlagbare Saugbohrungen aufweist, so dass bei Anlegen von Unterdruck an den Saugbohrungen der Klebefolienabschnitt auf der teilzylindermantelförmigen Außenfläche bzw. Teilmantelfläche der Rolltrommel 30 mittels Unterdruck gehalten wird.

Die Hubstangen 21.1, 21.2 der Halterung 20 sind mittels Befestigungsvorrichtungen 24.1, 24.2 an den Längsseiten des Auflagentisches 12 angeordnet, wobei die Befestigungsvorrichtungen 24.1, 24.2 es ermöglichen, dass die Hubstangen 21.1, 21.2 beispielsweise mittels entsprechender Zahnstangen oder eines oder mehrerer Zahnstangenantriebe in ihren Positionen am Auflagentisch 12 veränderbar sind. Hierbei ist beispielsweise ein Kurbelantrieb vorgesehen, der in die entsprechenden Zahnstangen eingreift, um die Hubstangen 21.1, 21.2 in der Höhe zu verstellen und/oder die Rolltrommel 30 horizontal entlang der Außenseite des Auflagentisches 12 zu bewegen. Ferner weisen die Befestigungsvorrichtungen 24.1, 24.2 auch Zahnstangen oder einen Zahnstangenantrieb auf, um die Halterung 20 mit den Hubstangen 21.1, 21.2 in horizontaler Richtung entlang des Auflagentisches 12 zu bewegen.

An der Stirnseite der Vorrichtung 10 (vgl. Fig. 2) ist zwischen den Standbeinen 16.3 und 16.4 im unteren Bereich eine Klebefolienrolle 40 mittels zweier rotierbar gelagerter Rollwalzen 41.1 41.2 rollend gelagert, wobei die Klebefolienrolle 40 über entsprechende (nicht sichtbare) Rollen nach außen geführt wird. An der stirnseitigen Außenseite ist für die abgezogene Klebefolienrolle 40 eine horizontal bewegbare Schneidvorrichtung 42 mit einem Schneidmesser angeordnet, um die abgezogene Klebefolie in der Breite zu schneiden. Oberhalb der Schneidvorrichtung 42 ist eine zweite mit einem Schneidmesser vorgesehene Schneidvorrichtung 44 vorgesehen, die ebenfalls in horizontaler Richtung bewegbar ist. Mittels der Schneidvorrichtung 44 wird die Länge des Klebefolienabschnitts geschnitten.

Darüber hinaus kann eine (hier nicht dargestellte) Schneidvorrichtung an der Vorrichtung 10 vorgesehen sein, um einen Ausschnitt bzw. ein Loch in den Klebefolienabschnitt für das Solarmodel zu schneiden, so dass in den Ausschnitt bzw. das Loch des Klebefolienabschnitts eine Anschlussdose auf der Rückseite des Solarmoduls 100 aufgenommen wird. Entsprechend dem Ausschnitt in dem Klebefolienabschnitt für das Solarmodul 100 ist entsprechend an der teilzylinderförmigen Rolltrommel 30 eine Aussparung 26 (vgl. Fig. 1) mittels der Rollensegmente 31.1a, ..., 31.3d ausgebildet.

Nachdem von der Klebefolienrolle 40 mittels der Schneidvorrichtungen 42, 44 ein Klebefolienabschnitt endlicher Länge passend zu der Rückseite des Solarmoduls 100 geschnitten worden ist und ggf. ein Ausschnitt für eine rückseitige Modulanschlussdose auf der Rückseite des Solarmoduls 100 in den Klebefolienabschnitt geschnitten worden ist, wird der Klebefolienabschnitt manuell auf der Außenseite der Rolltrommel 30 angeordnet, wobei sich hierbei die Rolltrommel 30 in einer Ruheposition oberhalb des Solarmoduls 100 befindet. Durch die Schneidvorrichtungen 42, 44 wird der Klebefolienabschnitt endlicher Länge passgenau in der Breite und Länge entsprechend den Maßen der Rückseite des Solarmoduls 100 zugeschnitten. Ferner wird ggfs. eine Aussparung für eine Anschlussdose auf der Rückseite des Solarmoduls in den, vorzugsweise selbstklebenden, Klebefolienabschnitt geschnitten.

Nachdem ggfs. ein Releaseliner oder eine Schutzfolie oder dergleichen von dem auf der Rolltrommel 30 gehaltenen Klebefolienabschnitt entfernt wird oder ist, wird anschließend mittels entsprechender Kurbelantriebe an den Befestigungsvorrichtungen 24.1, 24.2 die Rolltrommel 30 an ein Ende des Solarmoduls 100 durch vertikales Absenken und eine Verfahrbewegung in linearer Richtung bewegt, so dass ein erstes Ende des Klebefolienabschnitts auf der Aufnahmerolle 30 an der oberseitigen Rückseite des Solarmoduls 100 in Kontakt gebracht wird. Anschließend wird unter einer Abrollbewegung der Rolltrommel 30 der selbstklebende Klebefolienabschnitt auf die Rückseite des Solarmoduls 100 aufgebracht, wobei aufgrund des Eigengewichts der Rolltrommel 30 der Klebefolienabschnitt auf die Rückseite des Solarmoduls 100 gedrückt wird. Im Rahmen der Erfindung kann auch vorgesehen sein, dass zusätzlich eine weitere Pressvorrichtung zum Anpressen der Rolltrommel 30 vorgesehen ist. Bevor die Rolltrommel 30 auf der Rückseite des Solarmoduls 100 abgerollt wird, wird beispielsweise ein Verriegelungsstiftes 27 in mindestens eine Hubstange, z.B. die Hubstange 21.1, z.B. in ein entsprechendes Loch eingebracht , um die vertikale Hubbewegung der Hubstande 21.1 zu verrasten. Hierdurch ist die vertikale Bewegung der Rolltrommel 30 fixiert.

Alle genannten Merkmale, auch die den Zeichnungen allein zu entnehmenden sowie auch einzelne Merkmale, die in Kombination mit anderen Merkmalen offenbart sind, werden allein und in Kombination als erfindungswesentlich angesehen. Erfindungsgemäße Ausführungsformen können durch einzelne Merkmale oder eine Kombination mehrerer Merkmale erfüllt sein.

### Bezugszeichenliste

- 10: Vorrichtung
- 12: Auflagentisch
- 14: Auflagenfläche
- 16.1, ... 16.4: Standbein
- 18.1, 18.2: Schnellspanner
- 20: Halterung
- 21.1, 21.2: Hubstange
- 22: Querverbindung
- 26: Aussparung
- 27: Verriegelungsstift
- 30: Rolltrommel
- 31.1a, ... 31.1d: Rollensegment
- 31.2a, ... 31.2c: Rollensegment
- 31.3a, ... 31.3d: Rollensegment
- 40: Klebefolienrolle
- 41.1, 41.2: Rollwalzen
- 42: Schneidvorrichtung
- 44: Schneidvorrichtung
- 100: Solarmodul

## Patentansprüche

1. Vorrichtung (10) zum Reparieren eines, insbesondere fertig hergestellten, Solarmoduls (100), insbesondere zum Aufbringen einer Klebefolie auf die Rückseite eines, vorzugsweise auf der Rückseite defekten, Solarmoduls (100), mit einem längserstreckten, insbesondere horizontal ausgerichteten und/oder ortsfesten, Auflagentisch (12) für ein Solarmodul (100), wobei der Auflagentisch (12) für ein Solarmodul (100) eine Auflagenfläche (14) aufweist, und mit einer, vorzugsweise um eine horizontal ausgerichtete Rotationsachse, rotierbaren Aufnahmerolle (30) zum Aufnehmen eines Klebefolienabschnitts endlicher Länge für die Rückseite des zu reparierenden Solarmoduls (100), wobei eine Halterung (20) für die Aufnahmerolle (30) vorgesehen ist, wobei die Aufnahmerolle (30) für den Klebefolienabschnitt mittels der Halterung (20) am und/oder über dem Auflagentisch (12), insbesondere oberhalb des Auflagentisches (12), gehaltert angeordnet ist, wobei die Halterung (20) für die rotierbare Aufnahmerolle (30) in Bezug auf den Auflagentisch (12) entlang der Längserstreckung des Auflagentisches (12) bewegbar ist oder bewegt wird und die Halterung (20) für die rotierbare Aufnahmerolle (30) in Bezug auf den Auflagentisch (12) entlang der Längserstreckung des Auflagentisches (12) quer, insbesondere senkrecht, zur Längserstreckung des Auflagentisches (12) relativ bewegbar ist, so dass der, insbesondere vertikale, Abstand zwischen dem Auflagentisch (12) und der Aufnahmerolle (30) variabel einstellbar ist.

2. Vorrichtung (10) nach Anspruch 1, **dadurch gekennzeichnet, dass** die Halterung (20) für die Aufnahmerolle (30) relativ zum, vorzugsweise ortsfesten, Auflagentisch (12) in horizontaler Richtung und in vertikaler Richtung bewegbar ist, wobei insbesondere die Aufnahmerolle (30) von einer Ruheposition in eine Arbeitsposition bringbar ist und/oder wobei insbesondere die Aufnahmerolle (30) in einer Arbeitsposition mittels einer Verriegelungsvorrichtung (27) in der vertikalen Position verriegelbar oder verriegelt ist.

3. Vorrichtung (10) nach Anspruch 1 oder 2, **dadurch gekennzeichnet, dass** für die Bewegung der Halterung (20) wenigstens ein Halterungsantrieb, insbesondere ein Motor oder ein manueller Antrieb, vorgesehen ist.

4. Vorrichtung (10) nach einem der Ansprüche 1 bis 3, **dadurch gekennzeichnet, dass** die Aufnahmerolle (30) ein oder mehrere, insbesondere zylinderförmige oder teilzylinderförmige, Rollensegmente (31.1a, 31.1b, 31.1c, 31.1d; 31.2a, 31.2b, 31.2c; 31.3a, 31.3b, 31.3c, 31.3d) aufweist.

5. Vorrichtung (10) nach Anspruch 4, **dadurch gekennzeichnet, dass** die oder mehrere Rollensegmente (31.1a, 31.1b, 31.1c, 31.1d; 31.2a, 31.2b, 31.2c; 31.3a, 31.3b, 31.3c, 31.3d) miteinander koppelbar sind.

6. Vorrichtung (10) nach Anspruch 4 oder 5, **dadurch gekennzeichnet, dass** die, insbesondere zylinderförmige oder teilzylinderförmige, Aufnahmerolle (30) oder die Rollensegmente (31.1a, 31.1b, 31.1c, 31.1d; 31.2a, 31.2b, 31.2c; 31.3a, 31.3b, 31.3c, 31.3d) Befestigungsmittel, insbesondere Befestigungsklemmen oder mit Unterdruck beaufschlagbare Saugvorrichtungen, zum Befestigen des, vorzugsweise einzelnen, Klebefolienabschnitts endlicher Länge auf der Außenseite der Aufnahmerolle (30) aufweisen.

7. Vorrichtung (10) nach einem der Ansprüche 4 bis 6, **dadurch gekennzeichnet, dass** die Aufnahmerolle (30) einen inneren Rahmen (22) für die Rollensegmente (31.1a, 31.1b, 31.1c, 31.1d; 31.2a, 31.2b, 31.2c; 31.3a, 31.3b, 31.3c, 31.3d) aufweist, wobei die Rollensegmente (31.1a, 31.1b, 31.1c, 31.1d; 31.2a, 31.2b, 31.2c; 31.3a, 31.3b, 31.3c, 31.3d) auf oder an dem inneren Rahmen (22) der Aufnahmerolle (30) angeordnet oder anordbar sind.

8. Vorrichtung (10) nach einem der Ansprüche 1 bis 7, **dadurch gekennzeichnet, dass** die Aufnahmerolle (30) und/oder die Rollensegmente (31.1a, 31.1b, 31.1c, 31.1d; 31.2a, 31.2b, 31.2c; 31.3a, 31.3b, 31.3c, 31.3d) in Umfangsrichtung eine Aussparung (26) für einen Ausschnitt des Klebefolienabschnitts endlicher Länge aufweisen.

9. Vorrichtung (10) nach einem der Ansprüche 1 bis 8, **dadurch gekennzeichnet, dass** der Auflagentisch (12) eine Fixierungsvorrichtung (18.1, 18.2) für das, insbesondere zu reparierende, Solarmodul (100) aufweist.

10. Vorrichtung (10) nach einem der Ansprüche 1 bis 9, **dadurch gekennzeichnet, dass** die Vorrichtung (10) eine Aufnahmeeinrichtung (41.1, 41.2) für einen Klebefolienvorrat (40), insbesondere eine Klebefolienrolle (40), aufweist, wobei insbesondere die Aufnahmeeinrichtung (41.1, 41.2) an einer Stirnseite und/oder unterhalb der Auflagenfläche (14) des Auflagentisches (12) angeordnet ist.

11. Vorrichtung (10) nach einem der Ansprüche 1 bis 10, **dadurch gekennzeichnet, dass** die Vorrichtung (10) wenigstens eine Schneidvorrichtung (42, 44) zum Schneiden eines Klebefolienabschnitts von einem Klebefolienvorrat (40), insbesondere eine Klebefolienrolle (40), aufweist, wobei insbesondere die wenigstens eine Schneidvorrichtung (42, 44) an einer Stirnseite des Auflagentisches (12) und/oder oberhalb der Aufnahmeeinrichtung (41.1, 41.2) für einen Klebefolienvorrat (40) angeordnet ist und/oder wobei insbesondere eine Schneidvorrichtung (44) als Längenschneidvorrichtung (44) zum Schneiden der Länge des Klebefolienabschnitts und/oder eine Schneidvorrichtung (42) als Breitenschneidvorrichtung (42) zum Schneiden der Breite des Klebefolienabschnitts ausgebildet ist.

12. Vorrichtung (10) nach einem der Ansprüche 1 bis 11, **dadurch gekennzeichnet, dass** die Vorrichtung (10) eine Ausschnittsschneidvorrichtung zum Schneiden eines Ausschnitts, insbesondere eines Loches, in dem Klebefolienabschnitt für ein zu reparierendes Solarmodul (100) aufweist.

13. Verfahren zum Reparieren eines, insbesondere fertig hergestellten, Solarmoduls (100), insbesondere zum Aufbringen einer Klebefolie auf die Rückseite eines, vorzugsweise auf der Rückseite defekten, Solarmoduls (100), wobei auf die Rückseite ein, insbesondere ein aus Polyvinylfluorid (PVF) bestehender, Klebefolienabschnitt endlicher Länge unter Verwendung einer Vorrichtung (10) zum Reparieren eines Solarmoduls (100) nach einem der Ansprüche 1 bis 12 aufgebracht wird, wobei der auf der Außenseite der Aufnahmerolle (30) angeordnete Klebefolienabschnitt endlicher Länge mittels der Aufnahmerolle (30) an die Rückseite des Solarmoduls (100) angedrückt wird und durch eine, vorzugsweise lineare, Bewegung der Aufnahmerolle (30) entlang des Auflagentisches (12) die Aufnahmerolle (30) auf der Rückseite des Solarmoduls (100) abrollt und während der Abrollbewegung der Aufnahmerolle (30) der Klebefolienabschnitt endlicher Länge auf die Rückseite des Solarmoduls (100) aufgebracht wird.

14. Verwendung einer Vorrichtung (10) zum Reparieren eines, insbesondere fertig hergestellten, Solarmoduls (100) nach einem der Ansprüche 1 bis 12 zum Aufbringen einer, insbesondere eine aus Polyvinylfluorid (PVF) bestehende, Klebefolie auf die Rückseite eines, vorzugsweise auf der Rückseite defekten, Solarmoduls (100).
